# EUROPEAN PATENT SPECIFICATION

(11) **EP 1 096 077 B1**
(45) Date of publication and mention of the grant of the patent: **11.07.2007**
(21) Application number: 99830687.2
(22) Date of filing: 29.10.1999
(51) Int. Cl.: E04D 5/10, E04D 5/12, H05K 9/00

(54) **Method for making a bituminous coating with electrical and/or magnetic effect, bituminous coating thus obtained and use thereof**
Verfahren zur Herstellung einer bituminösen Beschichtung aufweisend einen elektrischen und/oder magnetischen Effekt, dadurch hergestellte bituminöse Beschichtung und deren Verwendung
Méthode de fabrication d'un revêtement bitumineux avec effet électrique et/ou magnétique, revêtement bitumineux ainsi fabriqué et son usage

(43) Date of publication of application: 02.05.2001
(73) Proprietor: Valli Zabban s.p.a., 50019 Sesto Fiorentino FI (IT)
(72) Inventor: Vignudelli, Adriano, 41057 Spilamberto MO (IT); Olmi, Eugenio, 59100 Prato PO (IT)
(74) Representative: Celestino, Marco

(56) References cited:
- EP-A- 0 400 711
- EP-A- 0 924 363
- WO-A-90/05223
- WO-A-92/08022
- DE-A- 3 535 807
- DE-A- 3 544 264
- DE-A- 19 705 180
- US-A- 2 405 987
- US-A- 3 297 461
- US-A- 4 287 248
- US-A- 4 306 927
- US-A- 4 396 665
- US-A- 5 000 999
- US-A- 5 656 354

## Description

### Field of the invention

The present invention relates to the field of civil engineering and more precisely it relates to a method for making a bituminous coating with electrical and/or magnetic effect.

Furthermore, the invention relates to a bituminous coating thus obtained.

In particular, the invention relates to a system for shielding surfaces of buildings from electromagnetic radiation by means of said coating, such as for example those generated by TV or cellular telephonic antennas, high voltage lines, etc.

Even if not exclusively, the invention relates to a bituminous coating for waterproofing horizontal surfaces of buildings such as foundations, roofs, terraces, etc. and shielding them from electromagnetic waves.

Always in particular, but not exclusively, the invention relates to a system for shielding by means of said coating metallic structures, ducts, etc. from stray currents, which cause serious damages for corrosion.

Furthermore, always not exclusively, the invention relates to a system for providing magnetic guides by means of said coating, in the industrial and road fields.

### Background of the invention

The problem is felt of shielding houses and offices from electromagnetic waves, whose negative effects on health and on well-being, notwithstanding not yet completely understood, are feared by people.

In particular, houses and offices are the places where people spend most of time, and then where the exposition is the largest.

New buildings have always thin walls, even if rugged enough, and are substantially permeable to electromagnetic waves.

In particular, roofs of buildings often support repeaters or other antennas that emit electromagnetic waves, whereby inhabitants are more exposed to this type of radiation. Near buildings there are sometimes high voltage lines, that create intense and variable electric and magnetic fields.

Another problem is that of the stray currents, which cause corrosion and then breakage of metal structures, ducts, etc. Such currents are produced by devices linked to the structure or they circulate in the ground surrounding the structure owing to adjacent electric plants. Corrosion of the metal appears in the points where the currents are transferred.

Concentrated corrosion can cause damages and perforation or initiation of fracture in tubes. Steel structures surrounded by ground are subject to this phenomenon as well, that causes damages thus requiring expensive maintenance and prevention systems.

A further problem is to provide magnetic guides on roads or on industrial paths. Usually, they are formed by electric cables laid underground or under road surfaces, for example under the centre or the side lines of roads. Such magnetic guides have the function of guiding a vehicle without driver, for example inside industrial plants, or alerting a driver of a car that is suitably equipped with appropriate electronic apparatus of the passage beyond the centre line or the side line of a road or of the presence of a bend. However, the roadworks for laying underground cables are expensive, they weaken the road surface and obstruct traffic.

The bituminous membranes are bituminous coatings customarily used for waterproofing and insulating surfaces. They are normally made in the form of sheets or rolls. The membranes are heated by fire at the moment of their application, and the coating obtained lasts a long time. Their composition can be varied according to their application, depending if, for example, they are used to cover roofs of buildings, walkways or roadways, structures to be waterproofed. Other bituminous coatings are obtained by lining directly surfaces with layers in turn of bitumen and of stiffening material. The latter membranes are made directly on place.

The waterproof bituminous membranes are normally made with addition of reinforcement material, for example glass fiber or polyester fiber, embedded between two layers of waterproof material made of elastomeric or plastomeric mix having bituminous nature. The membrane has a lower face, i.e. that which in use is arranged below, suitable for sticking to the surface to be waterproofed after flame heating on place. More precisely, the laying of the waterproof membrane is carried out starting from rolls of membrane unwound after flame heating of the lower face, with propane heating torch, operating substantially on a generatrix of the roll being unwound. The heating step is carried out at a temperature of about 300°C and has the object of melting the bituminous lower face so that the mix after cooling forms a continuous bonding with the surface same.

It is known moreover that bituminous membranes are permeable to magnetic fields and are good electric insulators.

US4287248 and EP0400711, describe a bituminous membrane with a metal foil embedded, to avoid consequences of elongation and wrinkling.

WO9005223 describe a bituminous membrane with reinforcement metal wires embedded.

US2405987 describes sheets capable of shielding rooms having inside roentgen apparatus.

US5656354 describes a fabric sewn with a metal foil for achieving antistatic properties.

### Summary of the invention

It is therefore object of the present invention to provide a method for making a bituminous coating that besides having waterproofing properties and good mechanical resistance against external agents has a magnetic effect, capable of solving the above problems and other problems of electrical, electromagnetic, magnetic type.

It is a first particular object of the present invention to provide a method for making a bituminous coating that is capable of shielding surfaces of buildings from electromagnetic radiation and that can be easily applicable both to new and existing buildings.

It is another object of the present invention to provide a waterproof bituminous coating applicable to surfaces of buildings for shielding the internal room from electromagnetic radiation without additional expensive works with respect to the known waterproofing techniques.

It is a first particular object of the present invention to provide a method for making a bituminous coating for shielding metallic structures, ducts, etc. from stray currents, which is easy to carry out and provides a permanent protection, as well as to provide a bituminous coating applicable to such metallic structures that carries out this method.

It is a further object of the present invention to provide a method for making a bituminous coating that is used as magnetic guide, in industrial and road surfaces.

These and other objects are achieved by the method according to the invention for making a bituminous coating with electrical and/or magnetic effect comprising the steps of:
- embedding in a bituminous coating, in the form of a bituminous membrane, at least one layer of conductor material,
characterised in that
- a step is provided of preparing in said membrane portions of connection of said conductor material to an adjacent conductor so that said portions of connection are electrically not isolated, said adjacent conductor being chosen among: a conductor belonging an adjacent membrane, a conductor connected to a voltage source, a conductor to be grounded..

The production steps of the membranes comprise:
- unwinding at least a roll of reinforcing material;
- rolling said layer of reinforcing material through a storage stand of bituminous material, whereby on both the faces of said material are thus deposited layers of bituminous material, its characteristic being that the reinforcing material is a conductor material. In particular, said reinforcing material is a net obtained from knitting or weaving lead wire, or it is a thin perforated and stretched metal sheet.

According to a physical general aspect of the invention a bituminous membrane made directly on place, or prefabricated flat or wound in a roll, for waterproofing and insulating horizontal surfaces of buildings, or for shielding structures from stray currents, or for making magnetic guides or for other uses with electrical and/or magnetic effect, is formed by a first face that sticks to the surface to coat and a second face facing towards the exterior, the membrane having the characteristic of being associated to at least a layer of conductor material that extends for all its surface.

The layer of conductor material is embedded in the matrix of the coating, advantageously about at the middle of its thickness.

The layer of conductor material embedded in the bituminous coating is preferably a net metal. The net can be made of knitted or woven metal lead wire or of thin perforated and stretched metal sheet. For the metal net knitted or woven a fibre can be used plated with highly conductor metals, for example inoxidizable precious metals.

The wire of the net is either made of or plated with metals chosen among: copper, aluminium, brass, iron, nickel, steel, carbon, titanium, other metals or conductor metal alloys.

The maximum distance between two conductor wires of the net is set between µ and 30mm. The net can be formed by either all conductor wires or by conductor wires alternated to one or several not conductor wires.

In a first embodiment of the invention, all the net is embedded in the membrane. Longitudinally to the membrane and at the edges thereof the net is covered along both sides by a web in flexible material so that the net is insulated from the bituminous material. Furthermore, the membrane has advantageously transversal strips of flexible material, for example fabric impermeable to bitumen, which coats the net along transversal lines. By pulling with suitable shear movement the transversal and/or longitudinal flexible material it is possible, in use, to uncover strips of net at the longitudinal sides of the membranes and/or transversal strips of net, thus tearing the bituminous material that coats it and allowing an electrical connection with the adjacent membranes or a grounding.

In a second embodiment, not all the net is embedded in the membrane, and precisely a central portion of net is embedded in the membrane whereas a first and a second lateral edge of net protrudes from opposite sides not embedded in the membrane. Also a head or tail edge of the membranes can be uncovered.

The net edges not embedded in the membrane are electrically not insulated. When preparing the membrane before or after the laying step, the first edge of net is bent on the first face and the second edge on the second face. This way, laying a roll of membrane partially overlapping another membrane already stuck, it is possible to match the two net edges on one another, thus electrically connecting the nets of the two membranes.

In both the embodiments, by laying on a same surface to coat different membranes adjacent to one another, a single membrane and a single net electrically connected is substantially obtained.

According to a first physical particular aspect of the invention, for shielding buildings from electromagnetic waves the application to the surfaces of said buildings is provided of coating elements formed by said bituminous membranes. The conductor material embedded in the coating or membrane is grounded for completing the shielding. Furthermore, the conductor materials belonging to different coating elements are electrically connected to one another in order to form a single conductor to be grounded.

Another physical particular aspect of the invention is that of shielding metallic structures from stray currents, by applying to the surfaces of said structures waterproof coating elements formed by said bituminous membranes. The conductor material embedded in the coating or membrane is grounded for completing the shielding. Furthermore, the conductor materials belonging to different coating elements are electrically connected to one another in order to form a single conductor to be grounded. If the surfaces to coat are tubular surfaces, for example for shielding ducts from stray currents, the bituminous membrane according to the invention has two uncovered net edges at opposite sides. The membrane, made of a strip of appropriate width, is wound helically, so that the two uncovered net edges match with each other.

The laying step on plane surfaces can be carried out in a normal way for bituminous membranes, by flame heating the face that sticks to the surface to shield. The longitudinal or transversal edges of the membranes are overlapping so that uncovered net edges of adjacent membranes selectively match with one another forming an electrical contact. Advantageously, the uncovered net edges can be coated with conductor paste, for example based on powder of graphite, copper, silver, aluminium embedded in a suitable pasty matrix that with heat produces a conductor linkage for the matching net edges, in order to assure a contact even where gaps are present.

In a different embodiment of the method of coupling the membranes, after the laying step of a first membrane that has a first edge of net uncovered, a second membrane is completely overlapped tat has also an edge of net uncovered, so that the two edges match with each other. Then, the first and second membrane are united with a side seam applied on place that crosses the two edges. Finally, the second membrane is overturned about the seam with respect to the first membrane already stuck to the surface.

The membrane can be supplied in rolls unwound progressively and flame applied on the surfaces to be shielded. After cooling the first edge of net of a first membrane matches the second edge of net of a second membrane and the electrical contact is obtained. The overlapping step of the membranes is carried out similarly to the prior art membrane without net. Then, the heating of the bonding line between the two membranes is carried out by means of penetration of the molten bitumen also through the two overlapped net edges. This penetration does not affect the electrical contact that is already obtained between the two membranes.

In particular cases, the bituminous membrane can also be mounted on vertical surfaces.

According to a third physical aspect of the invention, magnetic guides can be made by means of direct application on a road surface of a bituminous coating with magnetic effect. The coating, in the form of a membrane, is provided in rolls of not too much wide strip and having an embedded conductor material, in particular metal fabric net. The ends of the strip have uncovered net edges that overlap to each other forming the continuity of the conductor, for example with the aid of bonding by heating or with chemical pastes. Voltage is applied to portions of predetermined length of strip that form a current path and then a magnetic guide. The method of use of the coating according to the invention is particularly effective since the laying step of the web can be done very quickly and also with an appropriate equipment, thus rapidly providing magnetic guides for long distances. The strength of the reinforced bitumen is like that known and used in bituminous membranes for road works and allows to the magnetic guide to bear even high compressive and shear stress.

### Brief description of the drawings

Further characteristics and the advantages of the method for making a bituminous coating with electrical and/or magnetic effect, of the bituminous coating thus obtained and of its use according to the invention will be made clearer with the following description of an embodiment thereof, exemplifying but not limitative, with reference to the attached drawings, wherein:
- figure 1 shows a diagrammatical simplified view of the production of a bituminous membrane according to the present invention;
- figure 2 shows a top plan view of a net in fabric formed with lead wire and used for the production of the bituminous membrane of figure 1;
- figure 3 shows a cross sectional view of a membrane obtained with the process of figure 1;
- figure 4 shows a cross sectional view of a different embodiment of a bituminous membrane obtained with the process of figure 1 suitably modified;
- figure 5 shows a step of tearing away a side portion from the bituminous membrane of figure 4 to uncover edges of conductor metal net;
- figure 6 shows a perspective view of an unwinding step of a bituminous membrane with the uncovering steps of longitudinal and transversal strips of conductor net;
- figure 7 shows a step of mechanical and electrical coupling of two bituminous membranes according to the invention with the electrical matching to each other and relative grounding;
- figures 8 and 9 show a perspective view of a different embodiment of a bituminous membrane according to the invention;
- figures 10 and 11 show the bituminous membrane of figures 8 and 9 with the side edges of conductor net bent laterally towards opposite sides;
- figure 12 shows a step of coupling two bituminous membranes like those of figures from 8 to 11;
- figures from 13 to 15 show a third different embodiment of the step of mechanical and electrical coupling of two bituminous adjacent membranes, with the overlapping, seaming and overturning steps of the upper membrane with respect to the lower;
- figure 16 shows a step of coating a roof of a building with a membrane according to the invention;
- figure 17 shows a step of coating a metal tube with a bituminous membrane according to the invention;
- figure 18 shows the method of making a magnetic guide by means of a membrane according to the invention.

### Description of a preferred embodiment

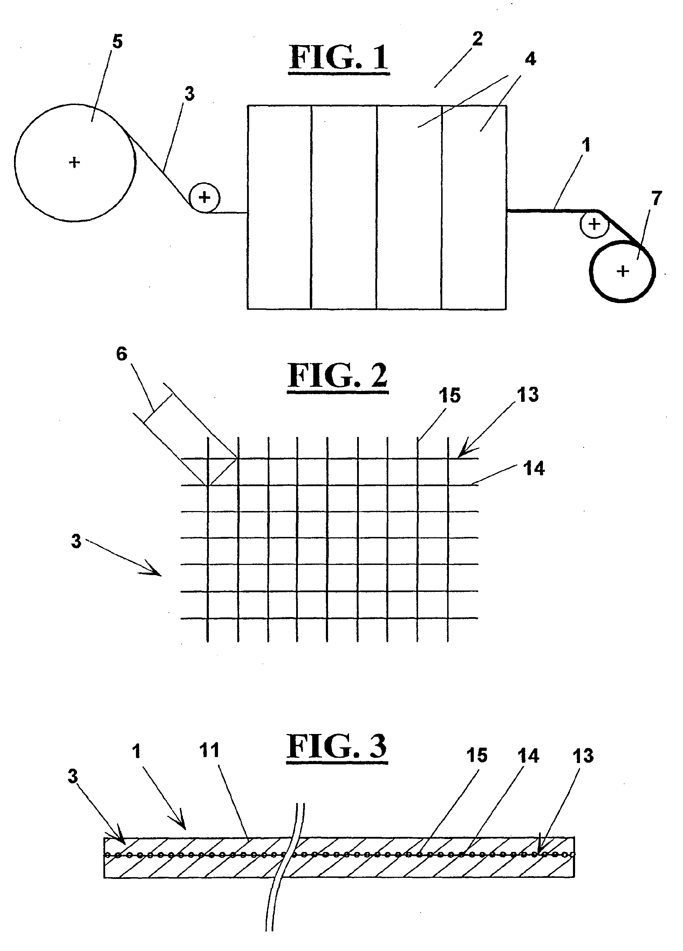

With reference to figure 1, a bituminous coating 1, in the form of a bituminous membrane, is produced in a plant 2 of known type.

More precisely, the production steps of membrane 1 provide the unwinding of at least a roll 5 of two-dimensional material 3 that is rolled through stands 4 and sunk in bituminous material. This way, on both faces of the two-dimensional material 3 layers of bituminous material are thus deposited. Membrane 1 is then wound forming a roll 7.

Normally, the two-dimensional material 3 has the function of a reinforcing material for membrane 1, and is completely embedded in the bituminous matrix.

According to the invention, the two-dimensional material 3 is a conductor material. It can be made of a net 13 obtained by knitting or weaving, like that shown in figure 2, with wires of weft 14 and warp 15. Wires 14 and 15 can be wires of conductor metal chosen among: copper, aluminium, brass, iron, nickel, steel, carbon, titanium, other metals or conductor metal alloys. Alternatively can be used textile thread, plastic or metal wire with not high conduction (for example steel) plated exteriorly with highly conductor metals, for example copper or inoxidizable precious metals.

The thickness of the wire, according to different uses, can be varied from 30µ to 2mm. The maximum distance 6 between conductor wires of a mesh of the net is preferably set between µ and 30mm. It is possible also to alternate conductor wires of weft 14 or of warp 15 to not conductor wires.

Alternatively to the net of metal knitted wire, the two-dimensional material 3 can be made of woven net, always in lead wire, or of thin perforated and stretched sheet.

A result of the production of bituminous membrane according to the invention is shown in the cross sectional view of figure 3, wherein with the numeral 11 the bituminous matrix has been indicated in which net 13 with wires of weft 14 and wires of warp 15 is embedded. Net 13 is embedded in matrix 11 of membrane 1 about at the middle of its thickness.

Membrane 1 thus obtained, besides having waterproof properties completely equal to the normal bituminous membranes, is also reinforced by the mechanical resistance of the conductor material 3, in particular net 13, and owing to the conductive properties of net 13 same it has also electromagnetic, magnetic and electric properties, that the normal waterproof bituminous membranes do not have.

The use of membrane 1 according to the invention can be done in many ways described hereinafter, exploiting the characteristics of electromagnetic induction of the conductor metal of the net, both in passive way, such as for shielding electromagnetic waves or neutralising stray currents, and in an active way, such as to provide magnetic guides.

With reference to figures from 4 to 7, in a first embodiment of the invention all net 13 is embedded in matrix 11 of membrane 1. In order to carry out the electric connection, such as grounding, electrical connection to adjacent membranes, or the connection to voltage sources, it is necessary to uncover portions of net so that they are not electrically insulated.

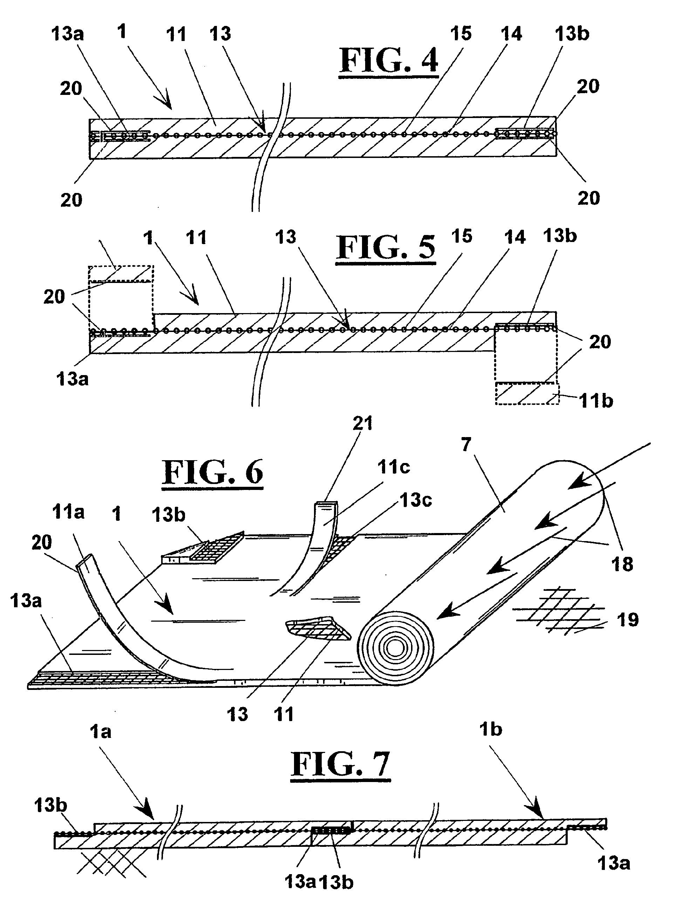

As shown in figure 4, at the edges of membrane 1 net 13 is covered at both sides by a strip 20 in flexible material, which insulates them enough from the bituminous material 11. Strip 20 can be for example waterproof fabric, for example cloth. Or can be a extruded resin, or also an insulated linen finished strip. Strip 20, having enough mechanical resistance, can be torn away on place by the operator so that side edges 13a and 13b of net 13 are uncovered, thus removing corresponding portions of bituminous matrix 11a and 11b.

Also transversally, in the direction of the weft of net 13, transversal strips of fabric 21 can be provided which, when torn away, remove portions 11c of bituminous matrix, thus uncovering a portion of net 13c (figure 6). The portions of uncovered net 13c, at a single or even at both the ends of membrane 1, allow the operator to cut the membrane and join it for creating an electrical connection with a previous or following membrane.

Both for the longitudinal uncovered portions of net 13a and 13b, and for the transversal portions of uncovered net 13c, it is possible to form a bonding line as shown in figure 7. More precisely, it is sufficient to couple the membrane by matching an uncovered edge of net 13a at a side membrane 1a, with an edge of uncovered net 13b at the opposite side of membrane 1b. The corresponding removed portions of bituminous matrix 11a and 11b (figure 5) allow that the overall thickness along the longitudinal bonding line is not increased. A similar step can be done for the head or tail junctions, provided that transversal net edges 13c are uncovered by removing portions 11c at the opposite longitudinal ends of membrane 1a and 1b.

Preferably, on uncovered net edges 13a, 13b or 13c a conductor substance is applied, such as a mixture or gel for example based on powder of graphite, copper, silver, aluminium embedded in a suitable pasty or gelatinous matrix. This way, by flame heating membrane 1 according to arrows 18 of figure 6 during the application step to surface 19 to coat, the conductor substance forms after heating a conductor link at the matching net edges 13a, 13b or 13c, so that a contact is assured even where physical gaps are present. Obviously, a correct pressing step of membrane 1a and 1b on surface 19 improves contact between metal and metal of the two net edges and, with the aid of the conductor substance, a steady contact for all the length of net edges 13a, 13b or 13c is obtained. A successive penetration of the bituminous material does not affect the continuous electric contact between net edges 13a, 13b or 13c.

With reference to figures from 8 to 12, in a different embodiment of the invention net 13, instead of being all embedded in bituminous matrix 11, has edges 13a and 13b already free from bitumen at the end of the production step of figure 1. This can be obtained by masking the net during the sinking step in the bitumen within stands 2, or by the application of templates then removed before or after winding in roll, as well as by hot washing and degreasing the net edges. In every case, it is important that the uncovered net edges 13a, 13b are eventually electrically not insulated. Also a transversal of head and/or tail edge of membrane 1 can be uncovered.

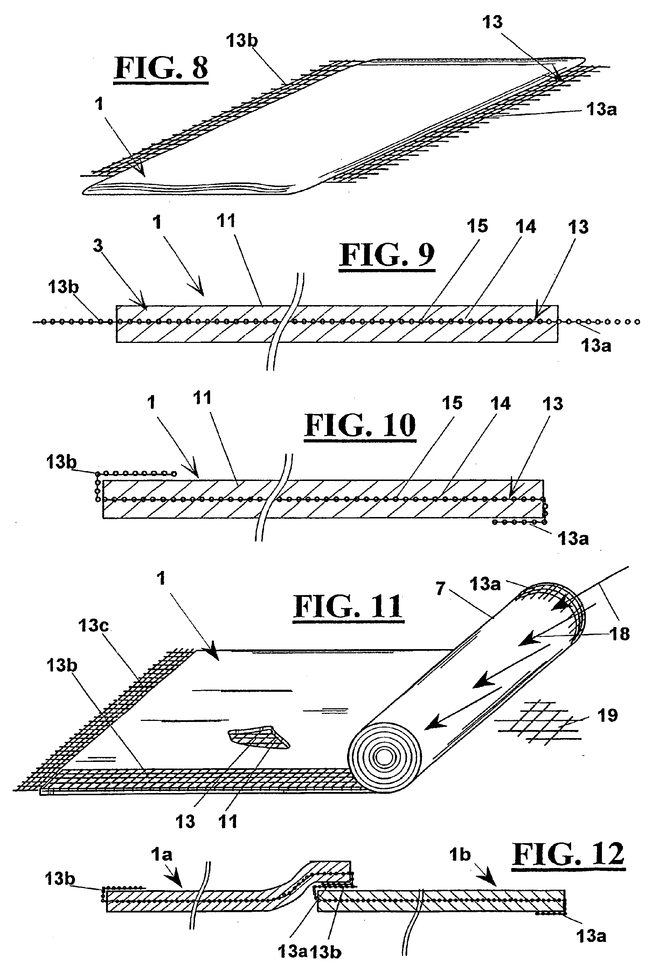

The roll 7 of membrane can be formed directly as shown in figures 10 and 11, with a first edge of net 13a bent onto the first face and a second edge 13b bent onto the second face membrane 1. This way, as shown in figure 12, laying a membrane 1a partially overlapping to another membrane 1b already stuck, it is possible to match the two edges of conductor net 13a and 13b on one another, thus electrically connecting the nets 13 of the two membranes 1a and 1b. In figure 12, as also in some of previous figures, membrane 1a and 1b are shown with the omission of a central part, for graphic reasons. Furthermore, the thickness of membranes has been increased with respect to the actual one. Normally a bituminous membrane has a thickness set between 2 mm to 1 cm.

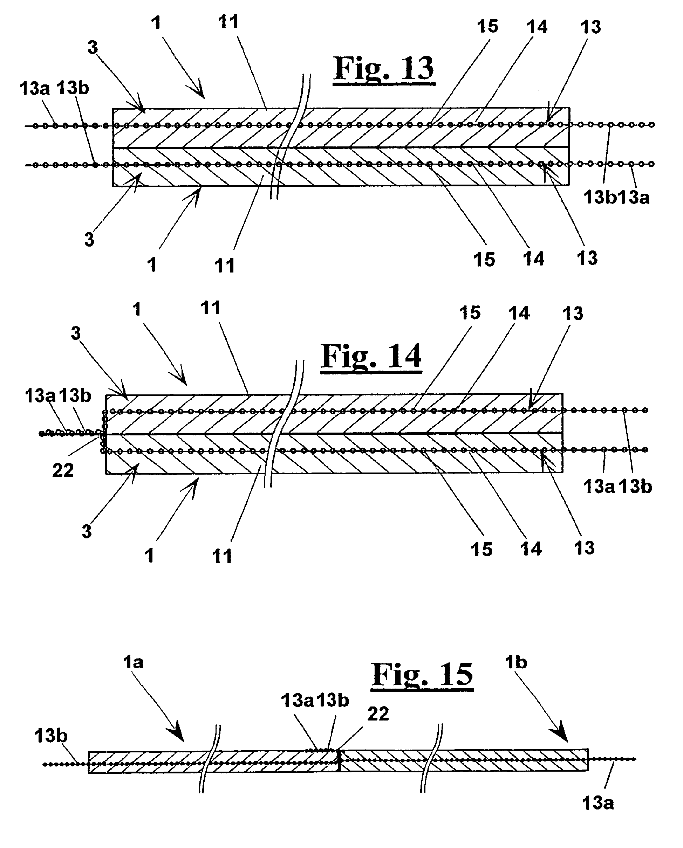

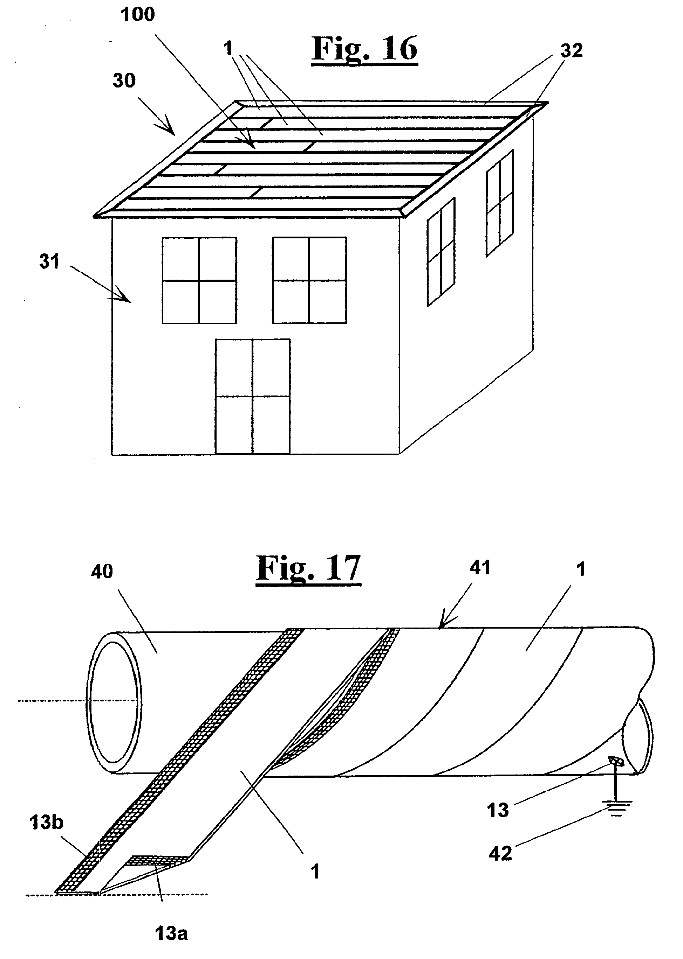

With reference to figures from 13 to 15, a different embodiment of the method of coupling the membranes provides that, after the laying step of a first membrane 1a, with an first uncovered net edge 13a, a second membrane 1b is completely overlapped having also a second uncovered net edge 13b, so that the two edges 13a and 13b are parallel to each other (figure 13). Then, the first and second membrane are jointed with a lateral seaming or welding 22, carried out on place, that crosses the two edges 13a and 13b (figure 14). Finally, second membrane 1b is overturned about line 22 about the already stuck first membrane 1a, as shown in figure 15.

In all the examples of figures 7, 12 and 15, laying a plurality of membranes 1 on a same surface to coat a substantially single membrane and then a single electrically connected net are eventually obtained.

With reference to figure 16, for shielding the roof 31 of a building 30 from electromagnetic waves it is possible the application in the way above described of a plurality of membranes 1 all electrically connected at the side and end edges, so that a single membrane 100 is formed. The conductor material of nets 13 associated to membranes 1 that is located along the perimeter of membrane 100 is grounded, for example to a gutter 32, for completing the shielding. Through the electrical connections between adjacent membranes like that shown in figures 7, 12 and 15, also the net 13 belonging to different adjacent membranes 1 is linked electrically in order to form a single conductor in turn grounded.

To shield high frequency electromagnetic waves, for example about 800MHz-1GHz like those of cellular telephones, it is preferential that net 13 has a diameter 6 (fig. 2) of about 150-300µ This can be obtained using a woven net of conductor wire with the diameter of 30-100µ. For shielding from lower frequency fields it is possible to use a net having meshes with wider width.

The application of prefabricated membranes can be substituted by making the membranes on place, by applying bituminous layers directly with the interposition of net 13, suitably linked to adjacent nets and grounded.

According to another physical particular aspect of the invention, shown in figure 17, a duct in steel 40 can be shielded from stray currents. More precisely, a bituminous membrane 1 large for example 10-30 cm can be applied helically, with side edges 13a and 13b uncovered in the same way shown in figures from 4 to 7. A single membrane tubular 41 is thus formed and, internally to it, a single metal tubular net completely insulated from tube 40 is provided. Advantageously, tube 40 can be rotated while progressively unwinding membrane 1.

The metal tubular net within membrane 41 is then grounded for completing the shielding without touching in any place the metal of tube 40 same. The variations of current in tube 40 by magnetic induction are picked up by the tubular net conductor of net 13 and, in the form of current they are discharged far from tube 40 same.

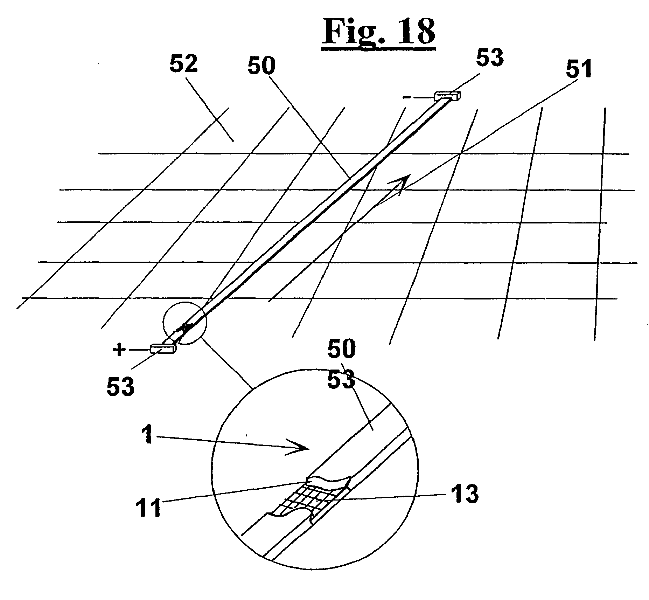

With reference to a third physical aspect of the invention, shown diagrammatically in figure 18, it is possible to provide a magnetic guide 50 for driving a self-propelled vehicle along a direction 51 on a surface of movement 52. More precisely, this can be achieved by applying directly to surface 52, for example a road surface or a path in an industrial plant, a strip of membrane 1 like that shown in figure 3. Membrane 1 is provided in rolls of web for example of 5-10 cm wide and having a net 13 embedded.

One of the ends of the magnetic guide 50, i.e. the head or tail edges of the web, is connected to a voltage supply 53 for generating driving currents that generate magnetic field lines that allow to determine direction 51. For obtaining appropriate length a plurality of portions of web can be connected in succession in the way shown for example in figure 7. Strip 50 can be applied easily to surface 52, such as a normal bituminous membrane.

## Claims

1. Method for making a bituminous coating with electrical and/or magnetic effect comprising the steps of:
- embedding in a bituminous coating (11), in the form of a bituminous membrane (1), at least one layer (13) of conductor material (3),
**characterised in that**
- a step is provided of preparing in said membrane unconverable portions (13a, 13b, 13c) of connection of said conductor material (3, 13) to an adjacent conductor so that said portions of connection are electrically not isolated, said adjacent conductor being chosen among: a conductor belonging to an adjacent membrane, a conductor connected to a voltage source, a conductor to be grounded.

2. Method according to claim 1, further comprising the steps of:
- unwinding from a roll (5) said conductor material (3) in the form of at least a web;
rolling said web of conductor material (3) through stands (4) containing bituminous material, depositing on both faces of said web layers of bituminous material (11), wherein said web of conductor material (3) is previously covered with predetermined portions of a flexible coating (20), said portions (13a, 13b, 13c) of connection being created pulling said flexible coating to uncover said portions (13a, 13b, 13c) of conductor material (3,13) causing it to be electrically not isolated.

3. method for making a bituminous coating with electrical and/or magnetic effect according to claim 1, **characterised by** the steps of:
- applying to a surface at least a first layer of bituminous material (11);
- arranging on said at least first layer of bituminous material said layer (13) of conductor material (3);
- applying on said layer (13) of conductor material (3) at least a second layer of bituminous material (11);
- said portions of connection being obtained leaving portions (13a, 13b) of said conductor material (3,13) exceeding said extension of said bituminous material (11);
- electrically connecting said exceeding portions (13a, 13b) of said layer (13) of conductor material (3) to other conductors.

4. Bituminous membrane with electrical and/or magnetic effect, for waterproofing and insulating horizontal surfaces of buildings, shielding metallic structures from stray currents, creating magnetic guides, or for uses with electrical and/or magnetic effect, **characterised in that** it comprises :
- a bituminous coating (11) or membrane (1), covering a predetermined surface,
- at least one layer (13) of conductor material (3) associated to said bituminous coating (11) and covering said surface,
said layer (13) of conductor material (3) has portions (13a, 13b, 13c) uncoverable from said bituminous coating (11), said layer (13) of conductor material (3) being electrically connectable to adjacent membranes (1a, 1b) or to other conductors or to a voltage supply.

5. Bituminous membrane according to claim 4, wherein said layer (13) of conductor material (3) embedded in the bituminous matrix (11) of said coating (1) is a metal net (13) chosen among: a net obtained from knitting or weaving a conductor wire (14, 15), a thin perforated and stretched metal sheet.

6. Bituminous membrane according to claim 5, wherein said metal wire (14, 15) is chosen among: copper, aluminium, brass, iron, nickel, steel, carbon, titanium, other metals or conductor metal alloys, metallic fibres plated with highly conductor metals, metallic fibres plated with precious conductor inoxidizable metals.

7. Bituminous membrane according to claim 5, wherein the maximum distance between two conductor wires (14, 15) of said net (13) is set between 50µm and 30mm

8. Bituminous membrane according to claim 5, wherein said net (13) is embedded completely in said coating (11), portions (13a, 13b, 13c) of said net (13) being provided covered on one or both sides by a web (20, 21) of flexible material that insulates them from said bituminous coating (11) and that can be torn pulling it with shear movement in order to uncover strips (13c) or side edges (13a, 13b) of net.

9. Bituminous membrane according to claim 5, wherein a central portion of said net (13) is embedded completely in said coating (11) and side net edges (13a, 13b, 13c) protrude from said coating.

10. Bituminous membrane according to claim 8 or 9, wherein said side edges (13a, 13b) of net (13) not embedded in the membrane (11) or uncovered edges are electrically not insulated, whereby overlapping the edge of a second membrane (1b) to the edge of a previously stuck first membrane (1a), two edges (13a, 13b) of conductor net (13) match on one another, thus electrically connecting the nets (13) of the two membranes (1a, 1b).

11. Method for coating a surface using a bituminous membrane (1) according any of the claims 4 to 10, **characterised in that** it comprises the steps of: removing at least a portion (11a, 11b, 11c) of said coating (11) for uncovering at least a portion (13a, 13b, 13c) of said conductor material (3, 13),applying by heating to a surface (19) at least a waterproofing element comprising said membrane (1), connecting said uncovered portion (13a, 13b, 13c) to another external conductor or to a voltage supply (53) or to ground (32,42).

12. Method for coating a surface according to claim 11, for shielding surfaces (30) of buildings (31) from electromagnetic waves, wherein the step of coating all said surfaces (30)is provided by arranging a plurality (100) of adjacent elements formed by said membrane (1), and by electrically connecting to one another the conductor materials (3) belonging to adjacent waterproofing elements (1) to form a single conductor to be grounded (32).

13. Method for coating a surface according to claim 11 wherein, for shielding metallic structures (40) from stray currents, the total coating (41) is provided of the surfaces of said structures by means of waterproofing elements formed by said bituminous membrane, the conductor materials (3,13) belonging to said waterproofing elements (1) being electrically connected to one another (13a, 13b) in order to form a single conductor to be grounded (42).

14. Method for coating a surface according to claim 13, where said surfaces to coat are tubular surfaces (40), wherein the step is provided of uncovering from opposite sides two edges (13a, 13b) of net (13) which are helically wound on said tubular surfaces (40), said uncovered net edges (13a, 13b) matching with each other along helical lines.

15. Method for coating a surface according to claim 11, wherein, for making a magnetic guide (51) on a surface (52) on which a self propelled vehicle can run, a step is provided of direct application on said surface of said membrane (50) in the form of a strip, the ends of said strip having uncovered net edges (13c) that overlap to each other forming a continue succession of sections, said continue succession of sections being supplied with voltage (53) and accordingly crossed by electric current thus forming said magnetic guide (51).

16. Method for coating a surface according to claims from 12 to 16, wherein the longitudinal and/or transversal edges of said membrane (1) are overlapping each other, uncovered net edges (13a, 13b) being provided on adjacent membranes (1a, 1b) selectively matching one another and forming an electrical contact, a step being provided of coating said uncovered edges (13a, 13b, 13c) of net (13) by means of a conductor paste chosen among powder of graphite, copper, silver, aluminium embedded in a pasty matrix or a gel that by hot application (18) forms a conductor linkage at said matching net edges.

17. Method for coating a surface according to claim 16, wherein after the step of laying a first membrane (1a) having a first an uncovered edge (13a) of net (13), a second membrane (1b) having also an uncovered edge (13b) of net (13) is completely overlapped thereon, wherein said two edges match with each other, the further step being provided of jointing said edges (13a, 13b) with a seaming or welding line (22), at the end of said jointing step said second membrane (1b) being overturned about said previously stuck first membrane (1a).

## Patentansprüche

1. Verfahren zur Herstellung einer bituminösen Beschichtung mit einer elektrischen und/oder magnetischen Wirkung, das die folgenden Schritte umfasst:
Einbetten mindestens einer Schicht (13) eines leitenden Materials (3) in eine bituminöse Beschichtung (11) in Form einer bituminösen Membran (1),
**dadurch gekennzeichnet, dass**
- ein Schritt die Herstellung von freilegbaren Verbindungsbereichen (13a, 13b, 13c) in der Membran umfasst, die eine elektrische Verbindung des leitenden Materials (3, 13) zu einem benachbarten Leiter sicherstellen, so dass die Verbindungsbereiche elektrisch nicht isoliert sind, wobei der benachbarte Leiter aus den folgenden Leitern ausgewählt wird: ein an eine benachbarte Membran angeschlossener Leiter, ein an eine Spannungsquelle angeschlossener Leiter, ein geerdeter Leiter.

2. Verfahren nach Anspruch 1, umfassend die folgenden Schritte:
- das leitende Material (3) in Form mindestens eines Netzes wird von einer Rolle (5) abgewickelt;
- das Netz aus leitendem Material (3) wird durch Walzen (4) geführt, die das bituminöse Material enthalten, wobei an beiden Seiten des Netzes Schichten aus bituminösem Material (11) angebracht werden, wobei das Netz aus leitendem Material (3) vorher an vorbestimmten Verbindungsbereichen mit einer flexiblen Beschichtung (20) abgedeckt wird, wobei die Verbindungsbereiche (13a, 13b, 13c) der elektrischen Verbindung **dadurch** hergestellt werden, dass die flexible Beschichtung abgezogen wird, um die Bereiche (13a, 13b, 13c) des leitenden Materials (3, 13) freizulegen, so dass sie elektrisch nicht mehr isoliert sind.

3. Verfahren zur Herstellung einer bituminösen Beschichtung mit einer elektrischen und/oder magnetischen Wirkung nach Anspruch 1, **dadurch gekennzeichnet, dass** das Verfahren die folgenden Schritte umfasst:
- an einer Oberfläche wird mindestens eine erste Schicht des bituminösen Materials (11) angebracht;
- auf der mindestens erster Schicht des bituminösen Materials wird die Schicht (13) des leitenden Materials (3) angeordnet;
- auf der Schicht (13) des leitenden Materials (3) wird mindestens eine zweite Schicht des bituminösen Materials (11) angeordnet;
- die Verbindungsbereiche der elektrischen Verbindung werden **dadurch** hergestellt, dass die Bereiche (13a, 13b) des leitenden Materials (3, 13) die Abmessungen des bituminösen Materials (11) überschreiten;
- die überschreitenden Bereiche (13a, 13b) der Schicht (13) des leitenden Materials (3) werden mit anderen Leitern elektrisch verbundenen.

4. Bituminöse Membran mit elektrischer und/oder magnetischer Wirkung zum Abdichten und zur Isolierung von horizontalen Oberflächen von Gebäude, zur Abschirmung metallischer Strukturen von Streuströmen, zur Herstellung von magnetischen Führungsbahnen oder zur Verwendung mit elektrischer und/oder magnetischer Wirkung, **gekennzeichnet durch**:
- eine bituminöse Beschichtung (11) oder eine Membran (1), die eine vorbestimmte Oberfläche abdeckt,
- mindestens eine Schicht (13) eines leitenden Materials (3), das mit der bituminösen Beschichtung (11) verbunden ist und die Oberfläche abdeckt,
- wobei die Schicht (13) des leitenden Materials (3) Bereiche (13a, 13b, 13c) aufweist, die von der bituminösen Beschichtung (11) nicht abgedeckt sind, wobei die Schicht (13) des leitenden Materials (3) an benachbarte Membranen (1a, 1b) oder an andere Leiter oder an eine Spannungsversorgung elektrisch anschließbar ist.

5. Bituminöse Membrane nach Anspruch 4, **dadurch gekennzeichnet, dass** die Schicht (13) des leitenden Materials (3), die in der bituminösen Matrix (11) der Beschichtung (1) eingebettet ist, ein Metallnetz (13) ist, das durch Stricken oder durch Weben einer Leiterleitung (14, 15) hergestellt wird, oder das ein dünnes, perforiertes und gestrecktes Metallblech ist.

6. Bituminöse Membran nach Anspruch 5, **dadurch gekennzeichnet, dass** der Metalldraht (14, 15) aus Kupfer, Aluminium, Messing, Eisen, Nickel, Stahl, Karbon, Titan, anderen Metallen oder Leitermetalllegierungen, metallischen Fasern, die mit Leitermetallen hoher Leitfähigkeit überzogen sind, oder metallische Fasern, die mit nicht oxidierbaren leitenden Edelmetallen überzogen sind, besteht.

7. Bituminöse Membran nach Anspruch 5, **dadurch gekennzeichnet, dass** der maximale Abstand zwischen zwei Leiterleitungen (14, 15) des Netzes (13) zwischen 50µm und 30mm beträgt.

8. Bituminöse Membran nach Anspruch 5, **dadurch gekennzeichnet, dass** das Netz (13) vollständig in der Beschichtung (11) eingebettet ist, wobei Bereiche (13a, 13b, 13c) des Netzes (13) auf einer oder beiden Seiten mit einem Netz (20, 21) aus einem flexiblem Material bedeckt sind, das diese Bereiche von der bituminösen Beschichtung (11) isoliert und das durch Ziehen mit einer Scherbewegung zerrissen werden kann, um Streifen (13c) oder seitliche Ränder (13a, 13b) des Netzes freizulegen.

9. Bituminöse Membran nach Anspruch 5, **dadurch gekennzeichnet, dass** ein zentral angeordneter Bereich des Netzes (13) vollständig im Inneren der Beschichtung (11) eingebettet ist und wobei seitliche Netzränder (13a, 13b, 13c) aus der Beschichtung hervorstehen.

10. Bituminöse Membran nach Anspruch 8 oder 9, **dadurch gekennzeichnet, dass** die seitlichen Ränder (13a, 13b) des Netzes (13), die nicht in der Membran (11) eingebettet sind, oder freiliegende Ränder elektrisch nicht isoliert sind, wobei der Rand einer zweiten Membran (1b) mit dem Rand einer vorher befestigten ersten Membran (1a) überlappt und zwei Ränder (13a, 13b) des leitenden Netzes (13) aufeinanderliegen, so dass die Netze (13) der beiden Membranen (1a, 1b) elektrisch verbunden werden.

11. Verfahren zum Beschichten einer Oberfläche mit einer bituminösen Membran (1) nach einem der Ansprüche 4 bis 10, **dadurch gekennzeichnet, dass** das Verfahren die folgenden Schritte umfasst:
- Entfernen mindestens eines Bereichs (11a, 11b, 11c) der Beschichtung (11), um mindestens einen Verbindungsbereich (13a, 13b, 13c) des leitenden Materials (3, 13) freizulegen, Aufbringen unter Erhitzung mindestens eines wasserdichten Elements, das die Membran (1) einschließt, auf eine Oberfläche (19), Verbinden der freigelegten Bereiche (13a, 13b, 13c) mit einem anderen externen Leiter, mit einer Spannungsversorgung (53) oder mit einer Erdung (32, 42).

12. Verfahren zum Beschichten einer Oberfläche nach Anspruch 11 zur Abschirmung der Oberflächen (30) von Gebäuden (31) von elektromagnetischen Wellen, wobei der Verfahrensschritt des Beschichtens aller Oberflächen (30) durch eine Anordnung einer Mehrzahl (100) von benachbarten Elementen erreicht wird, die durch die Membran (1) gebildet werden, und wobei die leitenden Materialien (3) miteinander elektrisch verbunden werden, die in den benachbarten wasserdichten Elementen (1) angeordnet sind, um einen zusammenhängenden Leiter zu bilden, der geerdet (32) werden kann.

13. Verfahren zum Beschichten einer Oberfläche nach Anspruch 11, **dadurch gekennzeichnet, dass** zur Abschirmung metallischer Strukturen (40) von Streuströmen eine vollständige Beschichtung (41) der Oberfläche der metallischen Strukturen mittels der wasserdichten Elemente bereitgestellt wird, die durch die bituminöse Membran gebildet werden, wobei die leitenden Materialien (3, 13), die zu den wasserdichten Elementen (1) gehören, elektrisch miteinander (13a, 13b) verbunden werden, um einen zusammenhängenden Leiter zu bilden, der geerdet werden kann (42).

14. Verfahren zum Beschichten einer Oberfläche nach Anspruch 13, **dadurch gekennzeichnet, dass** die zu beschichtenden Oberflächen röhrenförmige Oberflächen (40) sind, wobei der Schritt vorgesehen ist, an entgegengesetzten Seiten zwei Ränder (13a, 13b) des schraubenartig auf den röhrenförmigen Oberflächen (40) gewundenen Netzes (13) freizulegen, wobei die freiliegenden Ränder (13a, 13b) der Netze entlang der schraubenartigen Linien aufeinander liegen.

15. Verfahren zum Beschichten einer Oberfläche nach Anspruch 11, **dadurch gekennzeichnet, dass** zur Herstellung einer magnetischen Führungsbahn (51) auf einer Oberfläche (52), auf der ein selbstangetriebenes Fahrzeug sich fortbewegen kann, ein Verfahrensschritt ausgeführt wird, wobei auf der Oberfläche die Membran (50) in Form eines Streifens aufgebracht wird, wobei die Enden des Streifens freigelegte Ränder (13c) eines Netzes aufweisen und diese Ränder einander überlappen, um eine fortlaufende Reihe von Abschnitten zu bilden, die mit Spannung (53) versorgt wird und entsprechend von elektrischem Strom durchflossen wird, wodurch die magnetische Führungsbahn (51) gebildet wird.

16. Verfahren zum Beschichten einer Oberfläche nach einem der Ansprüche von 12 bis 16, wobei die längs und/oder transversal verlaufenden Ränder der Membran (1) einander überlappen, wobei die freigelegten Ränder (13a, 13b) des Netzes, die von den angrenzende Membranen (1a, 1b) bereitgestellt werden, jeweils zusammengebracht werden und einen elektrischen Kontakt bilden, wobei die freiliegenden Ränder (13a, 13b, 13c) des Netzes (13) mittels einer Leiterpaste beschichtet werden, wobei die Leiterpaste aus einem Pulver aus Graphit, Kupfer, Silber oder Aluminium gebildet ist, das in eine pastenförmige Matrix oder in ein Gel eingebettet ist und wobei die Leiterpaste durch Erhitzen (18) eine Leiterverbindung an den aufeinanderliegenden Rändern des Netzes bildet.

17. Verfahren zum Beschichten einer Oberfläche nach Anspruch 16, **dadurch gekennzeichnet, dass** nach dem Verfahrensschritt des Verlegens einer ersten Membran (1a), die einen ersten freiliegenden Rand (13a) des Netzes (13) aufweist, eine zweite Membran (1b) mit einem freiliegenden Rand (13b) des Netzes (13) mit der ersten Membran überlagert wird, wobei die beiden Ränder aufeinanderliegen, wobei der weitere Verfahrensschritt darin besteht, dass die Ränder (13a, 13b) durch eine Falz- oder Schweißnaht (22) verbunden werden, wobei am Ende des Verfahrensschrittes des Verbindens die zweite Membran (1b) um die vorher befestigte erste Membran (1a) umgeschlagen wird.

## Revendications

1. Procédé de fabrication d'un revêtement bitumeux avec un effet électrique et/ou magnétique comprenant les étapes suivantes :
- incorporer dans un revêtement bitumeux (11), sous la forme d'une membrane bitumeuse (1), au moins une couche (13) de matériau conducteur (3),
**caractérisé en ce que**
- une étape est prévue pour préparer dans ladite membrane des parties (13a, 13b, 13c) de connexion dudit matériau conducteur (3, 13) vers un conducteur adjacent de telle sorte que lesdites parties de connexion ne sont pas électriquement isolées, ledit conducteur adjacent étant choisi parmi : un conducteur appartenant à une membrane adjacente, un conducteur connecté à une source de tension, un conducteur devant être relié à la terre.

2. Procédé selon la revendication 1, comprenant en outre les étapes suivantes :
- dérouler depuis un rouleau (5) ledit matériau conducteur (3) sous la forme d'au moins une toile ;
rouler ladite toile de matériau conducteur (3) à travers des supports (4) contenant du matériau bitumeux, déposer sur les deux faces de ladite toile des couches de matériau bitumeux (11), dans lequel ladite toile de matériau conducteur (3) est précédemment recouverte avec des parties prédéterminées d'un revêtement flexible (20), lesdites parties (13a, 13b, 13c) de connexion étant créées en tirant ledit revêtement flexible pour découvrir lesdites parties (13a, 13b, 13c) de matériau conducteur (3, 13), les amenant à être non isolées électriquement.

3. Procédé de fabrication d'un revêtement bitumeux avec un effet électrique et/ou magnétique selon la revendication 1, **caractérisé par** les étapes suivantes :
- appliquer sur une surface au moins une première couche de matériau bitumeux (11) ;
- agencer sur ladite au moins une première couche de matériau bitumeux ladite couche (13) de matériau conducteur (3) ;
- appliquer sur ladite couche (13) de matériau conducteur (3) au moins une deuxième couche de matériau bitumeux (11) ;
- lesdites parties de connexion étant obtenues en laissant des parties (13a, 13b) dudit matériau conducteur (3, 13) dépassant de ladite extension dudit matériau bitumeux (11) ;
- connecter électriquement lesdites parties en excès (13a, 13b) de ladite couche (13) de matériau conducteur (3) à d'autres conducteurs.

4. Membrane bitumeuse avec un effet électrique et/ou magnétique, pour rendre étanche à l'eau et isoler des surfaces horizontales de bâtiments, protéger des structures métalliques des courants vagabonds, créer des guides magnétiques ou pour des utilisations avec un effet électrique et/ou magnétique, **caractérisée en ce qu'**elle comprend :
- un revêtement bitumeux (11) ou une membrane bitumeuse (1) recouvrant une surface prédéterminée,
- au moins une couche (13) de matériau conducteur (3) associée audit revêtement bitumeux (11) et recouvrant ladite surface,
ladite couche (13) de matériau conducteur (3) présente des partis (13a, 13b, 13c) pouvant être découvertes dudit revêtement bitumeux (11), ladite couche (13) de matériau conducteur (3) pouvant être connectée de manière électrique à des membranes adjacentes (1a, 1b) ou à d'autres conducteurs ou à une source de tension.

5. Membrane bitumeuse selon la revendication 4, dans laquelle ladite couche (13) de matériau conducteur (3) incorporée dans la matrice bitumeuse (11) dudit revêtement (1) est un filet métallique (13) choisi parmi : un filet obtenu par tricotage ou tissage d'un fil conducteur (14, 15), une feuille métallique fine perforée et étirée.

6. Membrane bitumeuse selon la revendication 5, dans laquelle ledit fil métallique (14, 15) est choisi parmi ; le cuivre, l'aluminium, le laiton, le fer, le nickel, l'acier, le carbone, le titane, d'autres métaux ou alliages de métaux conducteurs, des fibres métalliques plaquées avec des métaux hautement conducteurs, des fibres métalliques plaquées avec des métaux inoxydables conducteurs précieux.

7. Membrane bitumeuse selon la revendication 5, dans laquelle la distance maximale entre deux fils conducteurs (14, 15) dudit filet (13) est réglée entre 50 µm et 30 mm.

8. Membrane bitumeuse selon la revendication 5, dans laquelle ledit filet (13) est incorporé complètement dans ledit revêtement (11), des parties (13a, 13b, 13c) dudit filet (13) étant prévues recouvertes sur un ou les deux côtés d'une toile (20, 21) de matériau flexible qui les isole dudit revêtement bitumeux (11) et qui peut être déchiré en le tirant avec un mouvement de cisaillement afin de découvrir des bandes (13c) ou bords latéraux (13a, 13b) du filet.

9. Membrane bitumeuse selon la revendication 5, dans laquelle une partie centrale dudit filet (13) est incorporée complètement dans ledit revêtement (11) et les bords latéraux du filet (13a, 13b, 13c) font saillie depuis ledit revêtement.

10. Membrane bitumeuse selon la revendication 8 ou 9, dans laquelle lesdits bords latéraux (13a, 13b) du filet (13) non incorporés dans la membrane (11) et les bords découverts ne sont pas isolés électriquement, ce qui entraîne qu'en amenant à se chevaucher le bord d'une deuxième membrane (1b) sur le bord d'une première membrane (1a) précédemment collée, deux bords (13a, 13b) du filet conducteur (13) correspondent l'un sur l'autre, connectant ainsi électriquement les filets (13) des deux membranes (1a, 1b).

11. Procédé de revêtement d'une surface en utilisant une membrane bitumeuse (1) selon l'une quelconque des revendications 4 à 10, **caractérisé en ce qu'**il comprend les étapes suivantes; retirer au moins une partie (11a, 11b, 11c) dudit revêtement (11) pour découvrir au moins une partie (13a, 13b, 13c) dudit matériau conducteur (3, 13) appliquer par chauffage sur une surface (19) au moins un élément d'étanchéité à l'eau comprenant ladite membrane (1), connectant ladite partie découverte (13a, 13b, 13c) à un autre conducteur externe ou à une source de tension (53) ou à la terre (32, 42).

12. Procédé de revêtement d'une surface selon la revendication 11, pour protéger des surfaces (30) de bâtiments (31) d'ondes électromagnétiques, dans lequel l'étape de revêtement de toutes lesdites surfaces (30) est produite en agençant une pluralité (100) d'éléments adjacents formés par ladite membrane (1) et en connectant électriquement les uns aux autres les matériaux conducteurs (3) appartenant aux éléments d'étanchéité à l'eau adjacents (1) pour former un seul conducteur devant être relié à la terre (32).

13. Procédé de revêtement d'une surface selon la revendication 11 dans lequel, pour protéger des structures métalliques (40) de courants vagabonds, le revêtement total (41) est prévu des surfaces desdites structures au moyen d'éléments d'étanchéité à l'eau formés par ladite membrane bitumeuse, les matériaux conducteurs (3, 13) appartenant auxdits éléments d'étanchéité à l'eau (1) étant électriquement connectés les uns aux autres (13a, 13b) afin de former un seul conducteur devant être relié à la terre (42).

14. Procédé de revêtement d'une surface selon la revendication 13, dans lequel lesdites surfaces à revêtir sont des surfaces tubulaires (40), dans lequel l'étape est prévue pour découvrir depuis les côtés opposés deux bords (13a, 13b) du filet (13) qui sont enroulés de manière hélicoïdale sur lesdites surfaces tubulaires (40), lesdits bords du filet découverts (13a, 13b) correspondant l'un avec l'autre le long de lignes hélicoïdales.

15. Procédé de revêtement d'une surface selon la revendication 11, dans lequel, pour réaliser un guide magnétique (51) sur une surface (52) sur laquelle un véhicule motorisé peut avancer, une étape est prévue pour l'application directe sur ladite surface de ladite membrane (50) sous la forme d'une bande, les extrémités de ladite bande ayant des bords de filet découverts (13c) qui se chevauchent l'un sur l'autre, formant une succession continue de sections, ladite succession continue de sections étant alimentée avec de la tension (53) et traversée en conséquence par du courant électrique, formant ainsi ledit guide magnétique (51).

16. Procédé de revêtement d'une surface selon les revendications 12 à 16, dans lequel les bords longitudinaux et/ou transversaux de ladite membrane (1) se chevauchent les uns les autres, des bords de filet découverts (13a, 13b) étant prévus sur des membranes adjacentes (1a, 1b) correspondant les uns aux autres de manière sélective et formant un contact électrique, une étape étant prévue pour le revêtement desdits bords découverts (13a, 13b, 13c) du filet (13) au moyen d'une pâte conductrice choisie parmi de la poudre de graphite, du cuivre, de l'argent, d'aluminium incorporée dans une matrice pâteuse ou un gel par application à chaud (18) forme une liaison conductrice au niveau desdits bords de filet correspondants.

17. Procédé de revêtement d'une surface selon la revendication 16, dans lequel après l'étape de pose d'une première membrane (1a), ayant un premier bord découvert (13a) du filet (13), une deuxième membrane (1b) ayant également un bord découvert (13b) de filet (13) est complètement amenée à chevaucher celle-ci, dans lequel lesdits deux bords correspondent l'un à l'autre, l'étape supplémentaire étant prévue pour la jonction desdits bords (13a, 13b) avec une ligne d'agrafage ou de soudure (22), à la fin de ladite étape de jonction ladite deuxième membrane (1b) étant retournée autour de ladite première membrane (1a) collée précédemment.
